# EUROPÄISCHE PATENTSCHRIFT

(11) **EP 2 837 140 B1**
(45) Veröffentlichungstag und Bekanntmachung des Hinweises auf die Patenterteilung: **21.03.2018**
(21) Anmeldenummer: 13718148.3
(22) Anmeldetag: 12.04.2013
(51) Int. Cl.: H04L 12/28, G01R 21/133

(54) **VERFAHREN ZUM ERFASSEN VON LEISTUNGSVERBRAUCHSDATEN EINER WOHNEINHEIT SOWIE VERFAHREN ZUM STEUERN EINER WOHNEINHEIT**
METHOD FOR RECORDING POWER CONSUMPTION DATA OF A RESIDENTIAL UNIT AND METHOD FOR CONTROLLING A RESIDENTIAL UNIT
PROCÉDÉ DE DÉTECTION DES DONNÉES DE CONSOMMATION ÉLECTRIQUE D'UNE UNITÉ D'HABITATION AINSI QUE PROCÉDÉ DE COMMANDE D'UNE UNITÉ D'HABITATION

(30) Priorität: 12.04.2012 WO PCT/EP2012/056646
(43) Veröffentlichungstag der Anmeldung: 18.02.2015
(73) Patentinhaber: Aizo Group AG, 8952 Schlieren (CH)
(72) Erfinder: VESPER, Martin, 42399 Wuppertal (DE); DURRER, Cornel, CH-6333 Hünenberg See (CH)
(74) Vertreter: Hepp Wenger Ryffel AG
(86) Internationale Anmeldenummer: PCT/EP2013/057708
(87) Internationale Veröffentlichungsnummer: WO 2013/153208

(56) Entgegenhaltungen:
- EP-A2- 2 012 468
- US-A1- 2009 195 349
- US-A1- 2009 281 886

## Beschreibung

Die vorliegende Erfindung betrifft ein Verfahren zum Erfassen von Leistungsverbrauchsdaten einer Wohneinheit, ein Verfahren zum Steuern einer Wohneinheit, ein Computerprogrammprodukt sowie ein Verfahren zum Aus- oder Nachrüsten von Wohneinheiten, so dass Leistungsverbrauchsdaten erfasst werden können, gemäss den Oberbegriffen der unabhängigen Ansprüche.

Aus dem Stand der Technik sind verschiedene Verfahren und Vorrichtungen bekannt, welche eine Leistungserfassung einzelner Verbraucher oder einer gesamten Wohneinheit ermöglichen. Ausserdem sind Verfahren bekannt, welche einen Fernzugriff beispielsweise auf die Heizung einer Ferienwohnung erlauben.

So zeigt beispielsweise die US 2009/0195349 A1 ein System und ein Verfahren zum überwachen des Energieverbrauchs von Heimanwendungen. Hierzu sind in den einzelnen Steckdosen, in Mehrfachsteckdosen oder in den einzelnen Verbrauchern Messmittel angeordnet, welche den Energieverbrauch der angeschlossenen Verbraucher oder des Verbrauchers direkt ermitteln und an eine zentrale Basiseinheit übermitteln. Basierend auf diesen gemessenen Daten der Verbraucher kann der Energieverbrauch dargestellt werden. Es ist jedoch nachteilig, dass jeder Verbraucher selbst ein Messmittel aufweisen oder an einer Steckdose mit einem entsprechenden Messmittel angeschlossen werden muss. Falls ein Verbraucher direkt ohne ein entsprechendes Messmittel angeschlossen wird, kann sein Verbrauch nicht ermittelt und berücksichtigt werden. Ausserdem muss jedes Messmittel individuell adressierbar sein, um entsprechend im System erkannt und angesprochen zu werden.

EP2012132A1 offenbart eine Vorrichtung zur Identifizierung und Messung des Energieverbrauchs eines elektrischen Verbrauchers, so dass eine individuelle Kostenabrechnung je Verbraucher erstellt werden kann. Es kann auch der Energieverbrauch frei wählbarer Verbrauchergruppen erfasst werden, wobei diese Verbrauchergruppen nicht im gleichen Stromkreis angeordnet sein müssen. Aus diesen Verbrauchsdaten kann jedoch nicht auf ein bestimmtes Verhalten des Benutzers geschlossen werden.

EP2012468A2 zeigt ein Verfahren zur automatischen Szenenwahl bei einem Schaltvorgang eines szenentypischen Verbrauchers. Hierzu wird für eine bestimmte Szene ein typischer Verbraucher definiert, welcher bei einer Betätigung die ihm zugeordnete Szene auslöst. Eine Überwachung der Verbrauchsdaten ist nicht vorgesehen.

WO2011/039334A2 beschreibt ein Verfahren und eine Vorrichtung zur Datenübertragung in einem Wechselspannungsnetz, wobei der Sender mittels einer Stromquelle dem Wechselspannungsnetz ein Signal einprägt. Dieses Signal kann empfängerseitig mit einem Shunt ausgelesen werden.

WO2011/038912A1 zeigt eine Vorrichtung zum Modifizieren einer Wechselspannung sowie ein Verfahren zur Datenübertragung mittels einer modifizierten Wechselspannung. Hierzu wird in einer Hausinstallation direkt beim Verteilkasten die Wechselspannung derart modifiziert, dass ein Signal von einem im Verteilkasten angeordneten Sender an einen Empfänger, beispielsweise in einem Verbraucher, übermittelt werden kann. Somit wird beispielsweise ermöglicht, dass Verbraucher von einer zentralen Einheit gesteuert werden bzw. vordefinierte Szenen geschaltet werden.

Die US2009/281886A1 zeigt ein System zur Erfassung des Leistungsbedarfs eines Benutzers. Bei übermässiger Netzbelastung kann der Benutzer aufgefordert werden, seinen Leistungsbedarf zu reduzieren.

Es ist Aufgabe der Erfindung, die Nachteile des Standes der Technik zu überwinden. Insbesondere soll der Leistungsverbrauch in einer für den Benutzer verständlichen Form ermittelt und einfach kontrollierbar werden.

Diese Aufgabe wird durch die in den unabhängigen Patentansprüchen definierten Verfahren bzw. das Computerprogrammprodukt gelöst. Weitere Ausführungsformen ergeben sich aus den abhängigen Patentansprüchen.

Nachfolgend werden unter Formulierungen wie "A und/oder B" die folgenden Kombinationsmöglichkeiten verstanden: A or B, A, A not B, B, B not A, A and B, A xor B.

Unter Erfassen von Leistungsverbrauchdaten wird einerseits die direkte Messung des Leistungsverbrauchs beispielsweise eines Lastkreises im Verteilkasten verstanden, andererseits kann jedoch auch ein Leistungsverbrauch beispielsweise eines Lastkreises durch die Summe der einzeln gemessenen Verbräuche der am entsprechenden Lastkreis angeschlossenen Verbraucher ermittelt werden.

Der Begriff der Wohneinheit soll nachfolgend nicht auf Wohnungen oder Wohnhäuser reduziert werden. Unter einer Wohneinheit wird vielmehr aus Sicht der Stromversorgung eine Einheit verstanden, welche über einen eigenen Stromverteiler verfügt. Beispielsweise umfasst eine solche Wohneinheit ein Einfamilienhaus, eine einzelne Wohnung in einem Mehrfamilienhaus, eine Büroeinheit mit mehreren einzelnen Büros in einem Bürokomplex, eine Werkstatt, ein ganzes oder einen Teilbereich eines Gebäudes oder eine Lagerhalle. Ebenso kann aber unter einer Wohneinheit auch ein Fahrzeug, eine Eisenbahn, ein Schiff oder ein Flugzeug verstanden werden.

Unter einem Lastkreis einer Wohneinheit wie oben geschildert wird in einem Gebäudestromnetz ausgehend vom Netzzugang derjenige Anteil des Gebäudestromnetzes verstanden, welcher vom Verteiler abzweigt und zu einem oder mehreren Verbrauchern führt. Sollte in einem Kreis kein Verbraucher vorhanden sein, beispielsweise in einem leeren Zimmer ohne Lampe, handelt es sich nicht um einen Lastkreis im Sinne der Erfindung. Beispielsweise umfasst ein Lastkreis alle Netzsteckdosen mit angeschlossenen Verbrauchern sowie die Schalter und die Lampen eines Raumes. Meist verfügt jeder Lastkreis über eine eigene Sicherung, so dass im Schadensfall nur ein Netzausfall im entsprechenden Lastkreis auftritt und nicht die gesamte Wohneinheit vom Netz getrennt wird. Der Begriff Gebäudestromnetz ist dabei als Synonym für Gebäudestromnetze und ähnliche Verkabelungen, insbesondere auch für Bordnetze in Fahrzeugen, Eisenbahnen, Schiffen und Flugzeugen zu verstehen.

Unter einem Verbraucher wird jegliches Gerät verstanden, welches im Betrieb elektrischen Strom verbraucht. Beispiele sind Lampen, Fernseher, Radio, Ventilator, Klimaanlage, Heizgerät, Drucker, Monitor, Computer, elektrische Jalousien, Waschmaschine, Geschirrspüler, Kochherd, Kühlschrank, Kaffeemaschine, Toaster, Staubsauger, etc.

Unter Ansteuern wird beispielsweise ein direktes Ein- oder Ausschalten, Dimmen, leiser oder lauter Stellen, Schalten in den Standby-Betrieb, Öffnen oder Schliessen eines oder mehrerer Verbraucher oder die Übergabe eines entsprechenden Steuersignals an ein geeignetes, dem Verbraucher zugeordnetes Schaltmittel verstanden.

Elektrische Leistung ist die Leistung, welche als elektrische Energie pro Zeit bezogen oder geliefert wird. Die Leistung wird in Watt gemessen. Da nachfolgend die Leistung eines oder mehrer Verbraucher interessiert, wird für die Leistung, welche vom Verbraucher bezogen wird der Begriff Leistungsverbrauch benutzt. Unter einer Szene wird im Rahmen der Erfindung ein Schaltungszustand mindestens eines, bevorzugt mehrerer oder aller ansteuerbaren Verbraucher einer Wohneinheit oder von Teilbereichen einer Wohneinheit in Abhängigkeit von vordefinierten oder vordefinierbaren Situation oder Aktivitäten verstanden.

Aufrufen einer Szene bedeutet das gemeinsame Ansprechen aller ansteuerbaren Verbraucher oder deren zugeordneten Schaltmittel, wobei jeder Verbraucher oder sein zugeordnetes Schaltmittel sein erwartetes Verhalten kennt und entsprechend der aufgerufenen Szene den Leistungsverbrauch einstellt. Dies kann z.B. alle Leuchten in einem Raum oder auch sämtliche Verbraucher in einer Installation betreffen und kann auch für nachträglich eingesteckte Verbraucher gelten. Diese können bereits ein Standardverhalten kennen und bei einem Szenenaufruf entsprechend reagieren.

Raumbezogene Szenen wie z.B. Licht- oder Beschattungsstimmungen oder globale Szenen für die ganze Installation wie z.B. Kommen, Gehen, Klingeln, Panik, Schlafen, Aufwachen etc. können von einem Benutzer aufgerufen werden. Diese Szenen können von Automaten bei Eintreten bestimmter Situationen aufgerufen werden, um z.B. Präsenz zu markieren oder bei Dämmerung das Licht automatisch zu schalten. Szenen können auch von einem Benutzer, insbesondere in Abhängigkeit von seiner Aktivität, aufgerufen werden. Die Szenen bilden dabei typischerweise Benutzergewohnheiten ab. Beispielsweise kann eine Szene "Fernsehen" definiert sein, welche den Fernseher einschaltet, eine Hintergrundleuchte auf 100%, die Deckenbeleuchtung im Wohnzimmer auf 50% dimmt, die Jalousie schliesst und die anderen Verbraucher in der Wohneinheit nicht weiter beeinflusst. Eine Szene "Gehen" kann beispielsweise ein komplettes Ausschalten der Verbraucher in der Wohneinheit bedeuten, wobei auch einzelne Verbraucher, wie beispielsweise ein Kühlschrank von dieser Szene nicht beeinflusst werden. Gleichzeitig mit dem Ausschalten der Verbraucher kann beispielsweise die Szene "Gehen" auch eine Alarmanlage scharf stellen. Eine Szene "Panik" kann beispielsweise so definiert sein, dass dabei alle Leuchten in der Wohneinheit auf ihre maximale Helligkeit angehen, während andere Verbraucher nicht beeinflusst werden. Dabei ist eine Szene nicht an einen Lastkreis gebunden. Eine Szene umfasst keine vordefinierte Anzahl Verbraucher, sondern eigentlich alle Verbraucher der Wohneinheit, wobei nur der Status einzelner Verbraucher durch die Szene beeinflusst wird. Es versteht sich von selbst, dass die einzelnen Szenen beliebig benannt werden können.

In einem erfindungsgemässen Verfahren zum Erfassen von Leistungsverbrauchsdaten einer Wohneinheit wird der Leistungsverbrauch der Lastkreise einzeln gemessen und von einer Kontrolleinheit erfasst. Die Kontrolleinheit ordnet den so bestimmten Leistungsverbrauch den eingestellten Szenen zu. Dabei weist die Wohneinheit einen Verteiler mit mehreren Lastkreisen auf. In jedem Lastkreis ist mindestens ein Verbraucher angeordnet, wobei mindestens ein Verbraucher der Wohneinheit einzeln ansteuerbar ist. Jeder Lastkreis verfügt über Mittel zum Messen der im Lastkreis verbrauchten Leistung. Ausserdem weist die Wohneinheit eine Kontrolleinheit auf, welche in Abhängigkeit von vorbestimmten oder vorbestimmbaren Szenen den oder die Verbraucher ansteuert. Dabei müssen die angesteuerten Verbraucher der Kontrolleinheit nicht bekannt sein. Beispielsweise kann ein Verbraucher so konfiguriert sein, dass er bei einer Szene "Gehen" ausschaltet und/oder bei einer Szene "Panik" automatisch auf seine volle Leistung schaltet. Die Messung des Leistungsverbrauchs kann der eingestellten Szene einfach zugeordnet werden. Es wird nun beispielsweise möglich, den Leistungsverbrauch einer Szene, z.B. "Fernsehen" wie oben geschildert genau zu analysieren und dieser Szene einen Leistungsverbrauch zuzuordnen. Diese Zuordnung wird möglich durch eine zeitliche Korrelation des Ansteuerns der neuen Szene und der entsprechenden Änderung im Leistungsverbrauch der Wohneinheit. Es ist somit möglich, so genannte "Stromfresser"-Szenen zu identifizieren und gegebenenfalls zu vermeiden oder zu optimieren. So kann beispielsweise eine herkömmliche Glühbirne durch eine LED-Leuchte ersetzt werden.

Die vorbestimmten oder vorbestimmbaren Szenen werden in einer Kontrolleinheit abgelegt oder abgespeichert. In der Kontrolleinheit sind diese hinterlegten oder abgespeicherten Szenen wiederum auswählbar und abrufbar. Dabei können die Szenen direkt von der Kontrolleinheit ausgewählt werden, beispielsweise über einen vorprogrammierten oder vorprogrammierbaren zeitlichen Ablauf, oder von aussen über eine Stelleinheit ausgewählt werden. Die Stelleinheit kann beispielsweise ein Taster sein, welcher mit der Kontrolleinheit verbunden ist. Ein solcher Taster kann direkt in einem Lastkreis angeordnet oder beispielsweise über Funk oder andere Übertragungskanäle mit der Kontrolleinheit verbunden oder verbindbar sein.

Die Kontrolleinheit kann als eigenständiges Element ausgebildet, in einem Router integriert, in einem oder mehreren der Mittel zum Messen der in den Lastkreisen verbrauchten Leistungen abgebildet, in einem mit den Mitteln zum Messen verbundenen oder verbindbaren PC, etc. abgebildet sein.

Entsprechend einer Zuordnung einer bestimmten Szene zu einem Leistungsverbrauch kann auch eine Änderung des Leistungsverbrauchs einer Änderung der Szene zugeordnet werden. So kann beispielsweise ein Wechsel der Szene "Fernsehen" zu einer Szene "Lesen", bei welcher nur noch eine Stehlampe beim Sofa in Betrieb ist, erkannt werden. Der Nutzer erkennt so beispielsweise, dass für die Szene "Fernsehen" fast doppelt so viel Leistung verbraucht wird wie für die Szene "Lesen".

Die Szenen können lastkreisübergreifend einstellbar sein. So kann eine Szene "Fernsehen kühl" beispielsweise nicht nur die Verbraucher der Szene "Fernsehen", welche demselben Lastkreis zugeordnet sind umfassen, sondern auch ein Klimagerät, welches über einen separaten dreiphasigen elektrischen Anschluss mit 400V verfügt. Beispielsweise könnte auch ein Ventilator, welcher über ein Verlängerungskabel an einem anderen Lastkreis, insbesondere in einem anderen Raum, angeschlossen ist, der Szene "Fernsehen kühl" zugeordnet sein.

Der Leistungsverbrauch der einzelnen Szenen und/oder deren Summe kann graphisch und/oder als Text dargestellt werden. Dazu sind verschiedene Darstellungsmöglichkeiten denkbar, beispielsweise kann ein einfaches Zeit/Leistungs-Diagramm aufgezeichnet werden. Die einzelnen aktiven Szenen können beispielsweise auch als Kreise mit ihrer Grösse im Verhältnis zum aktuellen Leistungsverbrauch in Echtzeit dargestellt werden. Es versteht sich von selbst, dass auch andere Darstellungsarten denkbar sind.

Hier und im Folgenden wird unter einer Darstellung als Text auch eine Mitteilung als Push-Nachricht verstanden.

Eine Änderung des Leistungsverbrauchs kann graphisch mit einer Meldung zur geänderten Szene dargestellt werden. Wenn beispielsweise die Szene "Fernsehen" ausgeschaltet wird, kann ein entsprechender Abfall der Leistungskurve um 260W mit einer Meldung z.B. in Form einer Sprechblase "Fernsehen aus, -260W" zusätzlich beschriftet werden. Ein Wechsel der Szene "Fernsehen" mit 260W zu "Lesen" mit 100W kann dann beispielsweise durch "Fernsehen aus, Lesen ein, -160W" dargestellt werden. Ausserdem kann mit unterschiedlichen Farben eine Leistungserhöhung oder eine Leistungsreduktion gekennzeichnet werden.

Zusätzlich zum Leistungsverbrauch der Lastkreise kann auch der Leistungsverbrauch der einzelnen Verbraucher erfasst werden. Hierzu können die Verbraucher ein internes oder externes Schaltmittel aufweisen, welches direkt die Leistung erfasst und an die Kontrolleinheit übermittelt. Selbstverständlich sind auch andere Möglichkeiten der Leistungserfassung der einzelnen Verbraucher denkbar. Die Datenübertragung kann dabei leitungsgebunden direkt über die Netzleitung, beispielsweise wie in WO2011/039334A2 geschildert, oder über jedes andere Übertragungsmedium erfolgen.

Der Leistungsverbrauch der einzelnen Verbraucher kann auch graphisch und/oder als Text dargestellt werden. Wenn der Leistungsverbrauch der Verbraucher ermittelt wird, kann der Leistungsverbrauch einer Szene einfach optimiert werden. Beispielsweise kann erkannt werden, dass in der Szene "Fernsehen" der grösste Leistungsverbrauch von der Deckenbeleuchtung stammt. Der Anwender kann somit entscheiden, ob die Szene "Fernsehen" optimiert werden soll indem die Deckenbeleuchtung z.B. auf 50% gedimmt oder gar komplett ausgeschaltet wird. Weiter ist ein Ersatz herkömmlicher Glühmittel durch LEDs denkbar. Ebenso kann erkannt werden, wenn zur Szene "Fernsehen" noch ein zusätzlicher Verbraucher, beispielsweise eine Leselampe manuell hinzugeschaltet wird. Entsprechend kann der veränderte gemessene Leistungsverbrauch bezeichnet werden. Beispielsweise mit einer Sprechblase "Leselampe ein, Wohnzimmer, +50W". Falls ein bis anhin unbekannter Verbraucher zugeschaltet wird, kann dies beispielsweise mit "unbekannter Verbraucher ein, Wohnzimmer, +75W" beschriftet werden. Es ist denkbar, dass ein neuer Verbraucher bereits derart voreingestellt ist, dass er die Szenen "Gehen", "Panik" oder andere standardmässige definierte Szenen bereits erkennt und bei Aufruf dieser Szenen sich entsprechend verhält. Der Leistungsverbrauch des Lastkreises kann ermittelt und einer Szene zugeordnet werden, unabhängig davon, ob alle Verbraucher bekannt sind oder nicht. Sofern der unbekannte Verbraucher mit einem Schaltmittel zum Erfassen seines Leistungsverbrauchs ausgestattet ist, kann auch dieser gemessene Leistungsverbrauch an die Kontrolleinheit übermittelt werden. Falls kein solches Schaltmittel vorhanden ist, wird der Leistungsverbrauch der Szene im Lastkreis ermittelt. Der Leistungsverbrauch des unbekannten Verbrauchers kann dann beispielsweise aus der Differenz des aktuellen Leistungsverbrauchs zu einem früher ermittelten Leistungsverbrauch der Szene ermittelt werden.

Die Verbrauchsdaten der Wohneinheit, insbesondere der Leistungsverbrauch der einzelnen Lastkreise und/oder der einzelnen Verbraucher und/oder der einzelnen Szenen können von der Kontrolleinheit an ein externes Gerät, insbesondere über das Internet, übertragen werden. Die Verbrauchsdaten lassen sich somit an einem externen Gerät kontrollieren, überwachen, darstellen, analysieren und/oder weiterverarbeiten. Beispielsweise lassen sich dadurch Kostenabrechnungen basierend auf den einzelnen Szenen und/oder den einzelnen Verbrauchern erstellen. Durch eine Verbindung mit dem Internet lassen sich auch Geräte wie Smartphones, Tablet-PCs oder andere Geräte anschliessen. Der Anwender hat somit jederzeit und unabhängig von seinem Standort Zugriff auf die Verbrauchsdaten seiner Wohneinheit. Hierzu muss die Kontrolleinheit selbstverständlich mit dem Internet verbunden sein. Beispielsweise kann die Kontrolleinheit in einem bekannten Router integriert sein oder als Softwarepaket oder App im Router oder einem eigenständigen Computer installiert werden. Ebenso ist es beispielsweise denkbar, dass ein Netzbetreiber solche Daten zur Kapazitätsplanung verwenden kann.

Die Verbrauchsdaten können auf dem externen Gerät auch graphisch und/oder als Text, insbesondere wie vorgängig beschrieben, dargestellt werden.

Ein erfindungsgemässes Verfahren zum Steuern, insbesondere Fernsteuern einer Wohneinheit, umfasst das Ansteuern einer Kontrolleinheit, wobei die Kontrolleinheit mit einem Steuergerät, insbesondere über das Internet verbunden oder verbindbar ist, wobei einzelne Szenen ausgewählt und entsprechend die Verbraucher in der Wohneinheit angesteuert werden. Dabei weist die Wohneinheit einen Verteiler mit mindestens einem Lastkreis auf. In jedem Lastkreis ist mindestens ein Verbraucher angeordnet, wobei mindestens einer dieser Verbraucher einzeln ansteuerbar ist. Wenigsten ein Lastkreis verfügt über Mittel zum Messen der im Lastkreis verbrauchten Leistung. Ausserdem weist die Wohneinheit eine Kontrolleinheit auf, welche in Abhängigkeit von vorbestimmten oder vorbestimmbaren Szenen die Verbraucher ansteuert. Entsprechend wird von einem Steuergerät, beispielsweise einem Smartphone, einem Tablet-PC oder einem Taster, das Auswählen von Szenen mit entsprechendem Ansteuern der Verbraucher einer Wohneinheit möglich.

Unter Steuern einer Wohneinheit wird hier und im Folgenden verstanden, dass einzelne Szenen ausgewählt und die Verbraucher entsprechend der ausgewählten Szene angesteuert werden. Ebenfalls wird auch ein direktes Ein-/Ausschalten oder Dimmen einzelner Verbraucher sowie ein Einstellen bzw. Modifizieren einer Szene unter Steuern verstanden.

Der Leistungsverbrauch der Lastkreise kann einzeln gemessen und von der Kontrolleinheit erfasst werden. Die Kontrolleinheit kann den gemessenen Leistungsverbrauch den eingestellten und somit bekannten Szenen zuordnen. Dadurch wird ermöglicht, szenenspezifische Leistungsverbräuche zu vergleichen. Der Benutzer kann sein Verhalten zu einem sparsameren Verhalten verändern.

Es ist auch denkbar, dass der Leistungsverbrauch der einzelnen Verbraucher individuell erfasst und an die Kontrolleinheit übermittelt wird.

Die Verbrauchsdaten der Wohneinheit, insbesondere der Leistungsverbrauch der einzelnen Lastkreise und/oder der einzelnen Verbraucher und/oder der einzelnen Szenen können von der Kontrolleinheit an das Steuergerät übertragen werden. Entsprechend ist nicht nur das Steuern vom Steuergerät aus möglich, sondern es kann auch die Analyse der Verbrauchsdaten auf dem Steuergerät erfolgen. Hierzu kann beispielsweise eine entsprechende Software oder eine App auf dem Steuergerät installiert werden. Wenn die Verbrauchsdaten einem Netzbetreiber zur Verfügung gestellt werden, kann dieser beispielsweise Kapazitätsengpässe oder Leistungsspitzen durch gezieltes Ausschalten oder Blockieren von Szenen und/oder Verbrauchern verhindern.

Die Verbrauchsdaten können auf dem Steuergerät graphisch und/oder als Text, insbesondere wie vorgängig beschrieben, dargestellt werden. Es ist denkbar, dass der Benutzer die Verbrauchsdaten seinen Erfordernissen oder Vorlieben entsprechend darstellt und visualisiert.

Mindestens eine Szene kann über das Steuergerät konfiguriert werden. Es ist somit denkbar, dass nicht nur die vordefinierten Szenen angewählt und ausgelöst werden können, sondern auch Verbrauchereinstellungen einer Szene hinzugefügt oder entfernt oder der Leistungsverbrauch der Verbraucher angepasst werden kann. Dem Anwender stehen alle Möglichkeiten zur Optimierung seines Leistungsverbrauchs zur Verfügung.

Ein erfindungsgemässes Computerprogrammprodukt kann direkt in den internen Speicher eines digitalen Computers geladen werden und umfasst Softwareabschnitte, mit denen die Schritte wie vorab geschildert ausgeführt werden können, wenn das Produkt auf einem Computer läuft. Solche Computerprogramme können beispielsweise vom Internet als App auf ein Smartphone oder einen Tablet-PC herunter geladen werden. Das Computerprogrammprodukt erlaubt die Steuerung der Wohneinheit über voreingestellte Szenen. Es können die einzelnen Szenen jedoch auch modifiziert und/oder einzelne Verbraucher angesteuert werden. Ausserdem ist eine graphische Darstellung der Leistungsverbrauchsdaten denkbar. Die Programmierung eines solchen Computerprogrammproduktes kann vom Fachmann in an sich bekannter Art und Weise in üblichen Programmiersprachen erfolgen.

Ein erfindungsgemässes Verfahren zum Aus- oder Nachrüsten von Wohneinheiten, so dass die Verfahren wie vorab geschildert durchgeführt werden können, umfasst einen oder mehrere der nachfolgenden Schritte in beliebiger Kombination:
- Installieren von ansteuerbaren Schaltmitteln bei einem oder mehreren Verbrauchern und/oder Installieren von ansteuerbaren Verbrauchern,
- Installieren von Mitteln zum Messen von verbrauchter Leistung in einem oder mehreren Lastkreisen,
- Installieren einer Kontrolleinheit, welche derart ausgestaltet ist, dass die Kontrolleinheit in Abhängigkeit von vorbestimmten oder vorbestimmbaren Szenen die Verbraucher ansteuert und den Leistungsverbrauch der Lastkreise und/oder der Verbraucher erfasst und den eingestellten Szenen zuordnet.

Anhand von Figuren, welche lediglich Ausführungsbeispiele darstellen, wird die Erfindung im Folgenden näher erläutert. Es zeigen:
- Figur 1:: ein Gebäudestromnetz zur Ausführung des erfindungsgemässen Verfahrens,
- Figur 2:: ein Zeit/Leistungs-Diagramm des momentanen Leistungsverbrauchs des Gebäudestromnetzes,
- Figur 3:: ein Balkendiagramm der verbrauchten Energie pro verwendeter Szene, und
- Figur 4:: eine Darstellung des momentanen Leistungsverbrauchs in einem Kugeldiagramm auf einem Steuergerät.

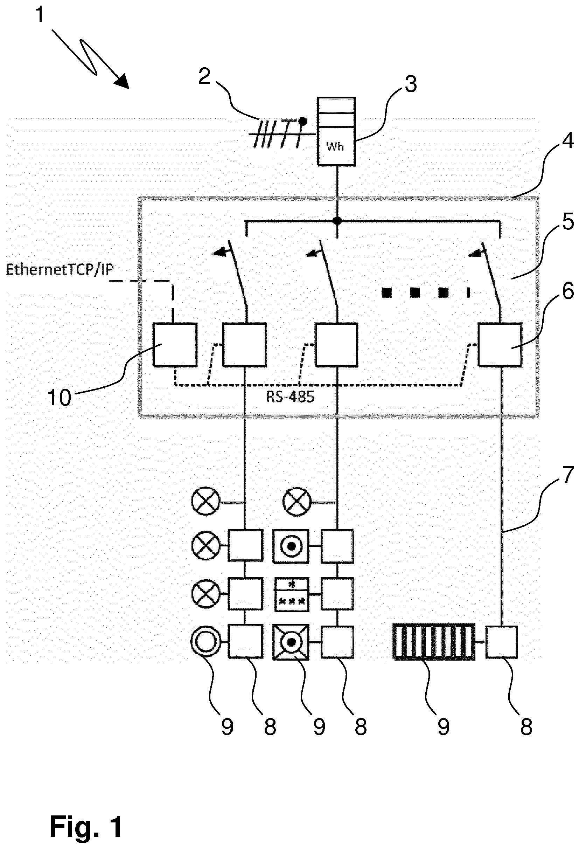

In Figur 1 ist ein Gebäudestromnetz 1 zur Ausführung des erfindungsgemässen Verfahrens dargestellt. Ausgehend von einem Netzzugang 2 mit Stromzähler 3 befindet sich im Gebäude ein Verteiler 4. In diesem Verteiler 4 wird das Wechselspannungsnetz auf die einzelnen Lastkreise 7 aufgeteilt, wobei jeder Lastkreis 7 eine eigene Sicherung 5 und ein Messmittel 6 in Form eines Stromzählers zur Messung der verbrauchten Leistung im Lastkreis 7 aufweist. Jeder Lastkreis 7 entspricht in einer konventionellen Gebäudeverkabelung in etwa einem Zimmer, wobei einzelne Geräte wie beispielsweise ein Backofen, eine Waschmaschine oder eine elektrische Heizung meist einen eigenen Lastkreis aufweisen. In jedem Lastkreis sind Verbraucher 9 entweder direkt oder über ein steuerbares Schaltmittel 8 angeschlossen.

Die Messmittel 6 sind untereinander über einen RS-485-Bus verbunden. Zusätzlich ist im Verteiler 4 auch eine Kontrolleinheit 10 angeordnet, welche ebenfalls mit den einzelnen Messmitteln 6 der Lastkreise 7 verbunden ist. Jedes Messmittel 6 übermittelt den gemessenen Leistungsverbrauch in seinem Lastkreis 7 über den RS-485-Bus in Echtzeit an die Kontrolleinheit 10. Es versteht sich von selbst, dass anstelle eines RS-485-Bus auch eine andere Datenverbindung zum Einsatz kommen kann. Die Kontrolleinheit 10 weist einen Anschluss für ein Ethernet bzw. zum Internet auf, so dass die Kontrolleinheit 10 mit externen Geräten verbunden werden kann. Die einzelnen steuerbaren Schaltmittel 8 und/oder die Verbraucher 9 selbst sind derart ausgerüstet, dass sie ihren Leistungsverbrauch selber ermitteln und an das Messmittel 6 ihres Lastkreises 7 übermitteln können. Das Messmittel 6 hat somit die Möglichkeit, den selbst gemessenen Wert des Leistungsverbrauchs an die Kontrolleinheit 10 zu übermitteln, und/oder die Summe der einzelnen Werte und/oder die einzelnen Werte, welche von den Verbrauchern 9 oder steuerbaren Schaltmitteln 8 übermittelt wurden, weiterzugeben.

In der Kontrolleinheit 10 oder in den einzelnen Messmitteln 6 sind nun so genannte Szenen hinterlegt. Diese Szenen können von einem Steuergerät oder von einem Taster ausgewählt und von der Kontrolleinheit anschliessend aufgerufen werden. So kann beispielsweise von der Kontrolleinheit 10 eine erste Szene "Fernsehen" aufgerufen werden, welche den Fernseher einschaltet, eine Hintergrundleuchte auf 50% und die Deckenbeleuchtung im Wohnzimmer auf 80% dimmt. Dabei müssen nicht alle Verbraucher 9 im selben Lastkreis 7 angeordnet sein. Beispielsweise können der Fernseher und die Hintergrundleuchte einem ersten Lastkreis 7 zugeordnet sein, während die Deckenbeleuchtung einem zweiten Lastkreis zugeordnet ist. Entsprechend erfassen die Messmittel 6 des ersten und des zweiten Lastkreises den Leistungsverbrauch der Szene "Fernsehen" mit 160W im ersten Lastkreis und mit 100W im zweiten Lastkreis. Diese beiden Werte werden an die Kontrolleinheit 10 übermittelt, welche den Leistungsverbrauch summiert und der ersten Szene "Fernsehen" die 260W zuordnet. In ähnlicher Weise können nun weitere Szenen z.B. "Lesen auf dem Sofa", "Lesen im Bett", "Kochen", "Essen", "romantisches Festessen", "Arbeiten im Büro", etc. definiert werden. Jeder einzelne Szenenaufruf wird dann die entsprechenden Verbraucher 9 in den einzelnen Lastkreisen 7 ein- oder ausschalten oder im Falle einer Leuchte auf eine bestimmte Helligkeit dimmen. Der Leistungsverbrauch wird jeweils pro Lastkreis 7 unabhängig von den einzelnen Verbrauchern 9 erfasst und an die Kontrolleinheit 10 übermittelt, welche die Zuordnung zu den einzelnen eingestellten Szenen vornimmt. Alternativ oder zusätzlich kann auch der Leistungsverbrauch pro Verbraucher 9 erfasst und an die Kontrolleinheit 10 übermittelt werden. Die Leistungsverbräuche können einzeln und/oder summiert, also pro Verbraucher 9, pro Lastkreis 7, pro Szene oder pro Wohneinheit 1, betrachtet und beispielsweise auf einem Display dargestellt werden.

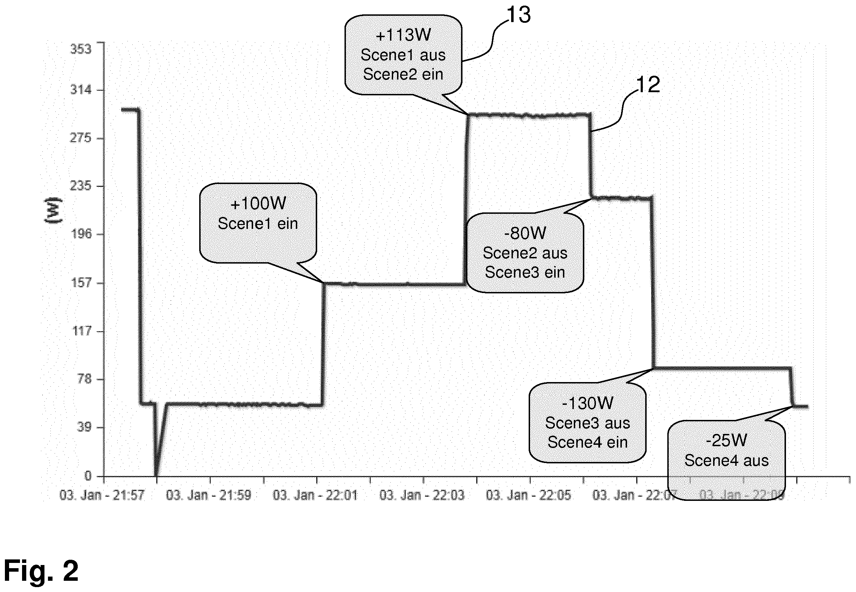

Figur 2 zeigt ein Zeit/Leistungs-Diagramm des momentanen Leistungsverbrauchs 12 des Gebäudestromnetzes 1. Dabei ist auf der x-Achse die fortlaufende Zeit und auf der y-Achse der Leistungsverbrauch aufgetragen. Die Kurve des Leistungsverbrauchs 12 wird in Echtzeit fortlaufend aktualisiert und jede Änderung des Leistungsverbrauchs wird mit einer Statusmeldung 13 kommentiert. Der Benutzer weiss somit sofort, was die Ursache für den veränderten Leistungsverbrauch ist. Es versteht sich von selbst, dass die dargestellte Verbrauchskurve nur ein Beispiel für die unzähligen Möglichkeiten der Darstellung ist und auch andere Darstellungsarten denkbar sind. Insbesondere sind auch andere Statusmeldungen denkbar, so kann beispielsweise nicht nur eine Veränderung des Leistungsverbrauchs ausgewiesen sondern auch jeweils alle aktivierten Szenen dargestellt werden. Die Texte der Statusmeldungen sind dabei beliebig konfigurierbar und die einzelnen Szenen beliebig benennbar.

Das gezeigte Zeit/Leistungs-Diagramm kann auf einem fest installierten Gerät direkt in der Wohneinheit, beispielsweise im Wohnzimmer dargestellt werden. Hierzu ist dieses Gerät direkt mit der Kontrolleinheit 10 (siehe Figur 1) verbunden oder die Kontrolleinheit 10 weist direkt ein Display zum Anzeigen des Zeit/Leistungs-Diagramms auf. Alternativ kann das gezeigte Zeit/Leistungs-Diagramm auch auf einem portablen Gerät, beispielsweise auf einem Smartphone, einem Tablet-PC oder einem Notebook angezeigt werden. Die Verbindung mit der Kontrolleinheit erfolgt dann vorzugsweise über das Internet.

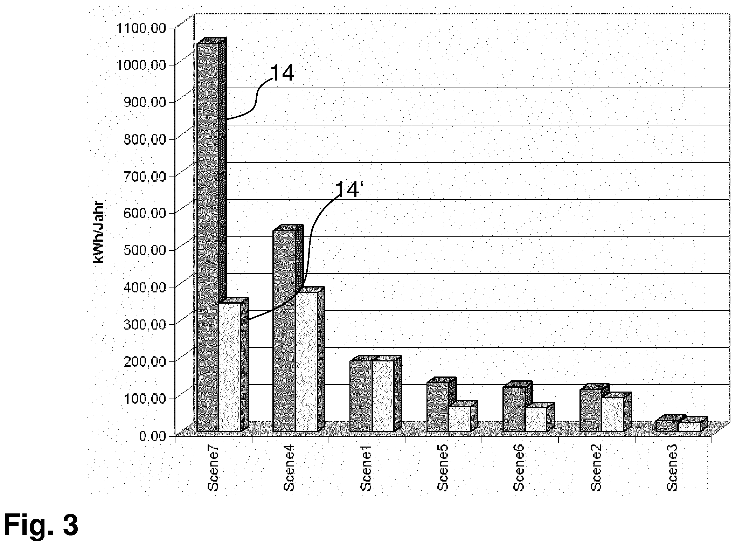

In Figur 3 ist ein Balkendiagramm der verbrauchten Energie 14, 14' pro verwendeter Szene und Jahr dargestellt. Dies ist eine weitere Darstellungsform zur Visualisierung des Leistungsverbrauchs. Es versteht sich von selbst, dass die Beschriftung der einzelnen Szenen individuell erfolgen kann. Der Benutzer erkennt sofort, welche Szene über das Jahr am meisten Energie 14 verbraucht. Dieser Energieverbrauch resultiert einerseits aus der Zeitdauer in welcher die entsprechende Szene benutzt wird und aus dem Leistungsverbrauch der Szene. Der Benutzer kann sich somit Gedanken machen, ob die Benutzungsdauer der entsprechenden Szene effektiv benötigt wird oder ob der Leistungsverbrauch der Szene optimiert werden kann. Beispielsweise kann durch geschicktes Ausschalten einzelner Verbraucher oder durch Ersatz einer Halogenlampe durch eine LED-Leuchte der Leistungsverbrauch einer Szene reduziert werden. Eine Veränderung der Szene kann beispielsweise direkt im Balkendiagramm durch einen hochgerechneten Energieverbrauch 14' dargestellt werden. So zeigt beispielsweise die Szene7 eine Reduktion der jährlich verbrauchten Energie von 1050kWh auf 350kWh lediglich durch den Ersatz von Halogen-Leuchtmittel mit neuen LED-Leuchtmittel.

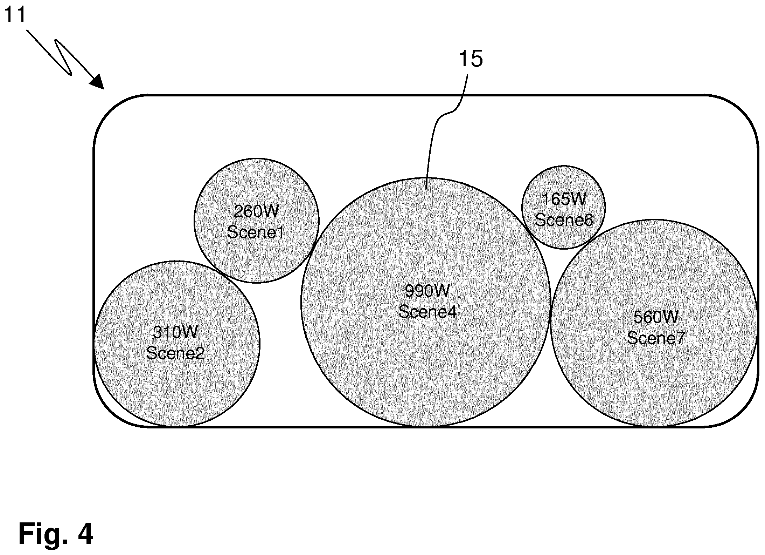

Figur 4 zeigt eine Darstellung des momentanen Leistungsverbrauchs einer Wohneinheit in einem Kreisdiagramm auf einem Steuergerät 11. Das Steuergerät ist beispielsweise ein Smartphone, ein Tablet-PC oder ein Notebook-Computer. Der momentane Leistungsverbrauch der benutzten Szenen wird direkt durch die Grösse der Kreise 15 dargestellt. Der Benutzer erkennt sofort, welche Szenen in der Wohneinheit aktiv sind und entsprechend zum gesamten Leistungsverbrauch der Wohneinheit beitragen. Ergänzend kann noch der effektive Wert eingetragen werden. Der Benutzer erkennt ausserdem auf einen Blick, welche Szene den grössten Leistungsverbrauch bewirkt und kann nötigenfalls Einfluss nehmen. Im gezeigten Beispiel verbraucht die Szene4 990W. Es versteht sich von selbst, dass die Beschriftung der einzelnen Szenen individuell erfolgen kann. So kann beispielsweise die Beschriftung der Szene4 an Stelle von "Scene4" auch "Arbeiten im Büro" lauten. Durch ein Auswählen der entsprechenden Szene können beispielsweise detaillierte Informationen zu dieser Szene, wie die einzelnen Verbraucher 9 (siehe Figur 1) mit entsprechendem Leistungsverbrauch dargestellt werden. Nicht benötigte Verbraucher können aus der Szene ausgeschlossen oder deren Verbrauch reduziert werden. Leuchten könnten beispielsweise gedimmt werden. Somit wird eine effiziente Überwachung und direkte Einflussnahme auf den Leistungsverbrauch der einzelnen Szene sowie der gesamten Wohneinheit möglich.

## Patentansprüche

1. Verfahren zum Erfassen von Leistungsverbrauchsdaten einer Wohneinheit, wobei
- die Wohneinheit einen Verteiler (4) mit mehreren Lastkreisen (7) aufweist,
- in jedem Lastkreis (7) mindestens ein Verbraucher (9) angeordnet ist,
- jeder Lastkreis (7) über ein Mittel (6) zum Messen der im Lastkreis (7) verbrauchten Leistung verfügt,
- die Wohneinheit eine Kontrolleinheit (10) aufweist, welche in Abhängigkeit von vorbestimmten oder vorbestimmbaren Szenen die Verbraucher (9) ansteuert,
- mindestens ein Verbraucher (9) einzeln ansteuerbar ist,
- eine Szene ein Schaltungszustand wenigstens eines, bevorzugt mehrerer oder aller ansteuerbaren Verbraucher (9) der Wohneinheit oder von Teilbereichen der Wohneinheit in Abhängigkeit von vordefinierten oder vordefinerbaren Situationen oder Aktivitäten ist,
**dadurch gekennzeichnet, dass** der Leistungsverbrauch der Lastkreise (7) einzeln von den Mitteln (6) zum Messen gemessen und von der Kontrolleinheit (10) erfasst wird und wobei die Kontrolleinheit (10) den so bestimmten Leistungsverbrauch den eingestellten Szenen zuordnet.

2. Verfahren nach Anspruch 1, **dadurch gekennzeichnet, dass** eine Änderung des Leistungsverbrauchs einer Änderung der Szene zugeordnet wird.

3. Verfahren nach Anspruch 1 oder 2, **dadurch gekennzeichnet, dass** die Szenen lastkreisübergreifend einstellbar sind.

4. Verfahren nach einem der Ansprüche 1 bis 3, **dadurch gekennzeichnet, dass** der Leistungsverbrauch der einzelnen Szenen und/oder deren Summe graphisch und/oder als Text dargestellt werden.

5. Verfahren nach Anspruch 4, **dadurch gekennzeichnet, dass** eine Änderung des Leistungsverbrauchs graphisch mit einer Meldung (13) zur geänderten Szene dargestellt wird.

6. Verfahren nach einem der Ansprüche 1 bis 5, **dadurch gekennzeichnet, dass** der Leistungsverbrauch der einzelnen Verbraucher (9) erfasst wird.

7. Verfahren nach einem der Ansprüche 1 bis 6, **dadurch gekennzeichnet, dass** Verbrauchsdaten der Wohneinheit, insbesondere der Leistungsverbrauch der einzelnen Lastkreise (7) und/oder der einzelnen Verbraucher (9) und/oder der einzelnen Szenen von der Kontrolleinheit an ein externes Gerät (11), insbesondere über das Internet, übertragen werden.

8. Verfahren nach Anspruch 7, **dadurch gekennzeichnet, dass** die Verbrauchsdaten auf dem externen Gerät (11) graphisch und/oder als Text dargestellt werden.

9. Verfahren nach einem der Ansprüche 1 bis 8, **dadurch gekennzeichnet, dass**
die Kontrolleinheit (10) mit einem Steuergerät (11), insbesondere über das Internet verbunden oder verbindbar ist und von diesem angesteuert wird oder ansteuerbar ist, wobei einzelne Szenen ausgewählt und entsprechend die Verbraucher (9) in der Wohneinheit angesteuert werden oder ansteuerbar sind.

10. Verfahren nach Anspruch 9, **dadurch gekennzeichnet, dass** Verbrauchsdaten der Wohneinheit, insbesondere der Leistungsverbrauch der einzelnen Lastkreise (7) und/oder der einzelnen Verbraucher (9) und/oder der einzelnen Szenen von der Kontrolleinheit (10) an das Steuergerät (11) übertragen werden.

11. Verfahren nach Anspruch 10, **dadurch gekennzeichnet, dass** die Verbrauchsdaten auf dem Steuergerät (11) graphisch und/oder als Text dargestellt werden.

12. Verfahren nach einem der Ansprüche 9 bis 11, **dadurch gekennzeichnet, dass** mindestens eine Szene über das Steuergerät (11) konfiguriert wird.

13. Computerprogrammprodukt, das direkt in den internen Speicher eines digitalen Computers geladen werden kann und Softwareabschnitte umfasst, mit denen die Schritte gemäss einem der Ansprüche 1 bis 8 und/oder 9 bis 12 ausgeführt werden, wenn das Produkt auf einem Computer läuft.

14. Verfahren zum Aus- oder Nachrüsten von Wohneinheiten, so dass Verfahren nach einem der Ansprüche 1 bis 8 und/oder 9 bis 12 durchgeführt werden können, umfassend einen oder mehrere der nachfolgenden Schritte in beliebiger Kombination:
- Installieren von ansteuerbaren Schaltmitteln (8) bei einem oder mehreren Verbrauchern (9) und/oder Installieren von ansteuerbaren Verbrauchern (9),
- Installieren von Mitteln (6) zum Messen von verbrauchter Leistung in einem oder mehreren Lastkreisen (7),
- Installieren einer Kontrolleinheit (10), welche derart ausgestaltet ist, dass die Kontrolleinheit (10) in Abhängigkeit von vorbestimmten oder vorbestimmbaren Szenen die Verbraucher (9) ansteuert und den Leistungsverbrauch der Lastkreise (7) erfasst und den eingestellten Szenen zuordnet.

## Claims

1. Method for recording power consumption data of a residential unit,
- the residential unit having a distributor (4) with a plurality of load circuits (7),
- at least one load (9) being arranged in each load circuit (7),
- each load circuit (7) having a means (6) for measuring the power consumed in the load circuit (7),
- the residential unit having a monitoring unit (10) which controls the loads (9) on the basis of predetermined or predeterminable scenes,
- at least one load (9) being individually controllable,
- a scene being a circuit state of at least one, preferably a plurality of or all controllable loads (9) of the residential unit or sections of the residential unit on the basis of predefined or predefinable situations or activities,
**characterized in that** the power consumption of the load circuits (7) is individually measured by the means (6) for measuring and recorded by the monitoring unit (10), and the monitoring unit (10) assigning the thus determined power consumption to the scenes which have been set.

2. Method according to Claim 1, **characterized in that** a change in the power consumption is assigned to a change in the scene.

3. Method according to Claim 1 or 2, **characterized in that** the scenes can be set across the load circuits.

4. Method according to one of Claims 1 to 3, **characterized in that** the power consumption of the individual scenes and/or their sum is/are represented graphically and/or in the form of text.

5. Method according to Claim 4, **characterized in that** a change in the power consumption is graphically represented with a message (13) relating to the changed scene.

6. Method according to one of Claims 1 to 5, **characterized in that** the power consumption of the individual loads (9) is recorded.

7. Method according to one of Claims 1 to 6, **characterized in that** consumption data of the residential unit, in particular the power consumption of the individual load circuits (7) and/or of the individual loads (9) and/or of the individual scenes, are transmitted from the monitoring unit to an external device (11), in particular via the Internet.

8. Method according to Caim 7, **characterized in that** the consumption data are represented graphically and/or in the form of text on the external device (11) .

9. Method according to one of Claims 1 to 8, **characterized in that**
the monitoring unit (10) is connected or is able to be connected to a control device (11), in particular via the Internet, and is controlled or is able to be controlled by said control device, individual scenes being selected and the loads (9) in the residential unit being controlled or being able to be controlled accordingly.

10. Method according to Claim 9, **characterized in that** consumption data of the residential unit, in particular the power consumption of the individual load circuits (7) and/or of the individual loads (9) and/or of the individual scenes, are transmitted from the monitoring unit (10) to the control device (11).

11. Method according to Claim 10, **characterized in that** the consumption data are represented graphically and/or in the form of text on the control device (11).

12. Method according to one of Claims 9 to 11, **characterized in that** at least one scene is configured using the control device (11).

13. Computer program product which can be loaded directly into the internal memory of a digital computer and comprises software sections which are used to carry out the steps according to one of Claims 1 to 8 and/or 9 to 12 when the product runs on a computer.

14. Method for equipping or retrofitting residential units, with the result that methods according to one of Claims 1 to 8 and/or 9 to 12 can be carried out, comprising one or more of the following steps in any desired combination:
- installing controllable switching means (8) in one or more loads (9) and/or installing controllable loads (9),
- installing means (6) for measuring consumed power in one or more load circuits (7),
- installing a monitoring unit (10) which is configured in such a manner that the monitoring unit (10) controls the loads (9) on the basis of predetermined or predeterminable scenes and records the power consumption of the load circuits (7) and assigns it to the scenes which have been set.

## Revendications

1. Procédé de collecte des données de consommation électrique d'une habitation, dans lequel
- l'habitation comporte un distributeur (4) doté de plusieurs circuits de charge (7),
- au moins un consommateur (9) est agencé dans chaque circuit de charge (7),
- chaque circuit de charge (7) est pourvu d'un moyen (6) de mesure de la puissance consommée dans le circuit de charge (7),
- l'habitation comporte une unité de contrôle (10), laquelle commande les consommateurs (9) en fonction de scènes prédéterminées ou pouvant être prédéterminées,
- au moins un consommateur (9) peut être commandé de façon individuelle,
- une scène est un état de commutation d'au moins un, de préférence une pluralité ou la totalité des consommateurs commandables (9) de l'habitation ou d'une partie de l'habitation dépendant de situations ou activités prédéfinies ou pouvant être prédéfinies, **caractérisé en ce que** la consommation électrique du circuit de charge (7) est mesurée individuellement par le moyen de mesure (6) et collectée par l'unité de contrôle (10) et dans lequel l'unité de contrôle (10) ordonne la consommation électrique ainsi déterminée aux scènes paramétrées.

2. Procédé selon la revendication 1, **caractérisé en ce qu'**une modification de la consommation électrique est ordonnée à une modification de la scène.

3. Procédé selon la revendication 1 ou 2, **caractérisé en ce que** les scènes sont paramétrables sur la totalité du circuit de charge.

4. Procédé selon l'une des revendications 1 à 3, **caractérisé en ce que** la consommation électrique des scènes individuelles et/ou de leur somme est représentée de manière graphique et/ou textuelle.

5. Procédé selon la revendication 4, **caractérisé en ce qu'**une modification (13) de la consommation électrique est représentée de manière graphique avec une notification à la scène modifiée.

6. Procédé selon l'une des revendications 1 à 5, **caractérisé en ce que** la consommation électrique des consommateurs individuels (9) est collectée.

7. Procédé selon l'une des revendications 1 à 6, **caractérisé en ce que** les données de consommation de l'habitation, en particulier la consommation électrique des circuits de charge (7) individuels et/ou des consommateurs (9) individuels et/ou des scènes individuelles, peuvent être transmises par l'unité de contrôle à un appareil externe (11), en particulier par Internet.

8. Procédé selon la revendication 7, **caractérisé en ce que** les données de consommation sont représentées de manière graphique et/ou textuelle sur l'appareil externe (11).

9. Procédé selon l'une des revendications 1 à 8, **caractérisé en ce que** l'unité de contrôle (10) est raccordée ou raccordable à un appareil de commande (11), en particulier par Internet, dans lequel des scènes individuelles sont sélectionnées et sont commandées ou peuvent être commandées selon le consommateur (9) dans l'habitation.

10. Procédé selon la revendication 9, **caractérisé en ce que** les données de consommation de l'habitation, en particulier la consommation électrique des circuits de charge (7) individuels et/ou des consommateurs (9) individuels et/ou des scènes individuelles, peuvent être transmises par l'unité de contrôle (10) à l'appareil de commande (11).

11. Procédé selon la revendication 10, **caractérisé en ce que** les données de consommation sont représentées de manière graphique et/ou textuelle sur l'appareil de commande (11).

12. Procédé selon l'une des revendications 9 à 11, **caractérisé en ce qu'**au moins une scène est configurée sur l'appareil de commande (11).

13. Produit de programme informatique, pouvant être chargé directement dans la mémoire interne d'un ordinateur et comportant des parties de logiciel avec lesquelles les étapes selon l'une des revendications 1 à 8 et/ou 9 à 12 peuvent être effectuées, lorsque le produit fonctionne sur un ordinateur.

14. Procédé d'équipement ou de mise à niveau des habitations, de sorte que des procédés selon l'une des revendications 1 à 8 et/ou 9 à 12 puissent être mis en oeuvre, comportant une ou plusieurs des étapes suivantes combinées de la manière souhaitée :
- installation de moyens de commutation pouvant être commandés (8) sur un ou plusieurs consommateurs (9) et/ou installation de consommateurs (9) pouvant être commandés,
- installation de moyens (6) de mesure de la consommation électrique dans un ou plusieurs circuits de charge (7),
- installation d'une unité de contrôle (10), laquelle est conçue de telle sorte que l'unité de contrôle (10) commande les consommateurs (9) en fonction de scènes prédéterminées ou pouvant être prédéterminées, collecte les données de consommation électrique des circuits de charge (7) et ordonne celles-ci aux scènes paramétrées.
